(19) Europäisches Patentamt
European Patent Office
Office européen des brevets

(11) **EP 4 756 438 A1**

(12) **EUROPEAN PATENT APPLICATION**
published in accordance with Art. 153(4) EPC

(43) Date of publication:
**10.06.2026 Bulletin 2026/24**

(51) International Patent Classification (IPC):
***G01R 19/165*** (2006.01)     ***G01R 19/04*** (2006.01)
***H02J 9/06*** (2006.01)

(21) Application number: 24848375.2

(22) Date of filing: **02.08.2024**

(52) Cooperative Patent Classification (CPC):
**G01R 19/04; G01R 19/165; H02J 9/06**

(86) International application number:
**PCT/CN2024/109437**

(87) International publication number:
**WO 2025/026421 (06.02.2025 Gazette 2025/06)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **03.08.2023 CN 202310979974**

(71) Applicant: EcoFlow Inc.
Shenzhen, Guangdong 518000 (CN)

(72) Inventors:
• WU, Dong
Shenzhen, Guangdong 518000 (CN)
• CHEN, Xi
Shenzhen, Guangdong 518000 (CN)
• WANG, Lei
Shenzhen, Guangdong 518000 (CN)
• LI, Weihan
Shenzhen, Guangdong 518000 (CN)

(74) Representative: Appelt, Christian W.
Boehmert & Boehmert
Anwaltspartnerschaft mbB
Pettenkoferstrasse 22
80336 München (DE)

(54) **POWER FAILURE DETECTION METHOD, POWER CONVERSION DEVICE, AND ENERGY STORAGE SYSTEM**

(57) This application provides a power failure detection method, including: obtaining a first fundamental wave signal of an alternating current (AC) at a first moment and a second fundamental wave signal at a second moment, where the second moment differs from the first moment by N sampling periods, and N is a positive integer; then obtaining a target signal orthogonal to the first fundamental wave signal based on the first fundamental wave signal and the second fundamental wave signal; quickly obtaining a real-time voltage amplitude of the AC at the first moment based on the first fundamental wave signal and the target signal; and determining a power failure detection result of the AC based on the real-time voltage amplitude.

Obtain a first fundamental wave signal of an AC at a first moment and a second fundamental wave signal at a second moment — S10

Obtain a target signal orthogonal to the first fundamental wave signal based on the first fundamental wave signal and the second fundamental wave signal — S20

Obtain a real-time voltage amplitude of the AC at the first moment based on the first fundamental wave signal and the target signal — S30

Determine a power failure detection result of the AC based on the real-time voltage amplitude — S40

FIG. 3

# EP 4 756 438 A1

## Description

### CROSS-REFERENCE TO RELATED APPLICATIONS

This application claims priority to Chinese Patent Application No. 2023109799748, filed with the China National Intellectual Property Administration on August 3, 2023 and entitled "POWER FAILURE DETECTION METHOD, POWER CONVERSION DEVICE, AND ENERGY STORAGE SYSTEM", which is incorporated herein by reference in its entirety.

### TECHNICAL FIELD

This application relates to the field of power supply technologies, and in particular, to a power failure detection method, a power conversion device, and an energy storage system.

### BACKGROUND

The descriptions herein merely provide background information related to this application, and do not necessarily constitute exemplary technologies.

Whether an uninterruptible power supply (UPS) can quickly detect, when a mains supply is subjected to a power failure, that the mains supply is subjected to a power failure and quickly switch the power supply is one of important performance indicators for measuring the UPS. In the related art, an alternating current (AC) phase-locked loop algorithm is usually used to detect a voltage amplitude of the mains supply. When the voltage amplitude of the mains supply decreases to a specific threshold, it is considered that the mains supply is subjected to a power failure. However, because an integration element exists in a loop in the AC phase-locked loop algorithm, a detection speed is relatively slow. When the mains supply is suddenly subjected to a power failure, it takes a relatively long time to detect that the voltage amplitude of the mains supply falls below a threshold, which results in a relatively long time for switching to the power supply, that is, a UPS switching time.

It should be noted that the information disclosed in the foregoing background is only used to enhance understanding of the background of this application. Therefore, the information may include information that does not constitute the related art known to a person of ordinary skill in the art.

### SUMMARY

This application provides a power failure detection method, a power conversion device, and an energy storage system.

An embodiment of this application provides a power failure detection method, including: obtaining a first fundamental wave signal of an alternating current (AC) at a first moment and a second fundamental wave signal at a second moment, where the second moment differs from the first moment by N sampling periods, and N is a positive integer; then obtaining a target signal orthogonal to the first fundamental wave signal based on the first fundamental wave signal and the second fundamental wave signal; obtaining a real-time voltage amplitude of the AC at the first moment based on the first fundamental wave signal and the target signal; and finally determining a power failure detection result of the AC based on the real-time voltage amplitude.

An embodiment of this application further provides a power conversion device, including a power converter, an AC input interface, a backup power input interface, a load interface, and a controller. The AC input interface is configured to connect to an AC power supply to receive an AC. The load interface is configured to connect to an electrical load. The backup power input interface is configured to connect to a backup power supply to receive power from the backup power supply. The power converter is connected to the AC input interface, the load interface, and the backup power input interface, and the power converter is configured to perform power conversion on power supplied by the AC or the backup power supply and then supply power to the electrical load through the load interface. The controller is electrically connected to the AC input interface and the power converter, and the controller is configured to control the power converter, and further configured to perform the power failure detection method in any one of the foregoing first aspect or the embodiments of the first aspect.

An embodiment of this application further provides an energy storage system, including a power conversion device and a battery device. The power conversion device is the power conversion device according to any one of the foregoing embodiments.

An embodiment of this application further provides an electronic device, including a processor and a memory. The memory is configured to store a program, an instruction, or code. The processor is configured to execute the program, the instruction, or the code in the memory, so as to complete the power failure detection method in any one of the foregoing first aspect or the embodiments of the first aspect.

An embodiment of this application further provides a power failure detection apparatus, including an obtaining module, a first processing module, a second processing module, and a power failure detection module. The obtaining module is configured to obtain a first fundamental wave signal of an AC at a first moment and a second fundamental wave signal at a second moment, where the second moment differs from the first moment by N sampling periods, and N is a positive integer. The first processing module is configured to obtain a target signal orthogonal to the first fundamental wave signal based on the first fundamental wave signal and the second fundamental wave signal. The second processing module is configured to obtain a real-time voltage amplitude of the AC at the first moment based on the first fundamental wave signal and the target signal. The power failure detection module is configured to determine a power failure detection result of the AC based on the real-time voltage amplitude.

An embodiment of this application further provides a computer-readable storage medium, storing a computer program. The computer program is loaded by a processor to perform the power failure detection method in any one of the foregoing first aspect or the embodiments of the first aspect.

Details of one or more embodiments of this application are provided in the following drawings and descriptions. Other features, objectives, and advantages of this application become apparent from the specification, the drawings, and the claims.

**BRIEF DESCRIPTION OF THE DRAWINGS**

To describe the technical solutions of the embodiments of this application or the exemplary technology more clearly, the following briefly describes the drawings required for describing the embodiments or the exemplary technology. Apparently, the drawings in the following description merely show some of the embodiments of this application, and a person of ordinary skill in the art may derive the drawings of other embodiments from these drawings without creative efforts.

FIG. 1 is a schematic diagram of a phase-locked loop in the related art.
FIG. 2 is an application scenario diagram of a power failure detection method according to an embodiment of this application.
FIG. 3 is a flowchart of a power failure detection method according to an embodiment of this application.
FIG. 4 is a waveform diagram of a real-time voltage amplitude detected by a phase-locked loop in the power failure detection method and the related art shown in FIG. 3.
FIG. 5 is a detailed flowchart of step S40 in FIG. 3.
FIG. 6 is another detailed flowchart of step S40 in FIG. 3.
FIG. 7 is a schematic diagram of a power conversion device according to an embodiment of this application.
FIG. 8A is a schematic diagram of an energy storage system according to an embodiment of this application.
FIG. 8B is another schematic diagram of an energy storage system according to an embodiment of this application.
FIG. 9 is a schematic diagram of an electronic device according to an embodiment of this application.
FIG. 10 is a schematic diagram of a power failure detection apparatus according to an embodiment of this application.

**DETAILED DESCRIPTION**

It should be noted that terms as "first" and "second" in the specification and claims of this application and in the drawings are used for distinguishing similar objects and not used for describing any particular order or sequence.

In addition, it should be noted that, the method disclosed in the embodiments of this application or the method shown in the flowcharts includes one or more steps for implementing the method. An execution order of a plurality of steps may be exchanged with each other and some steps may also be deleted without departing from the scope of the claims.

Some embodiments are described below with reference to the drawings. The following embodiments and features in the embodiments may be combined with each other in the case of no conflict.

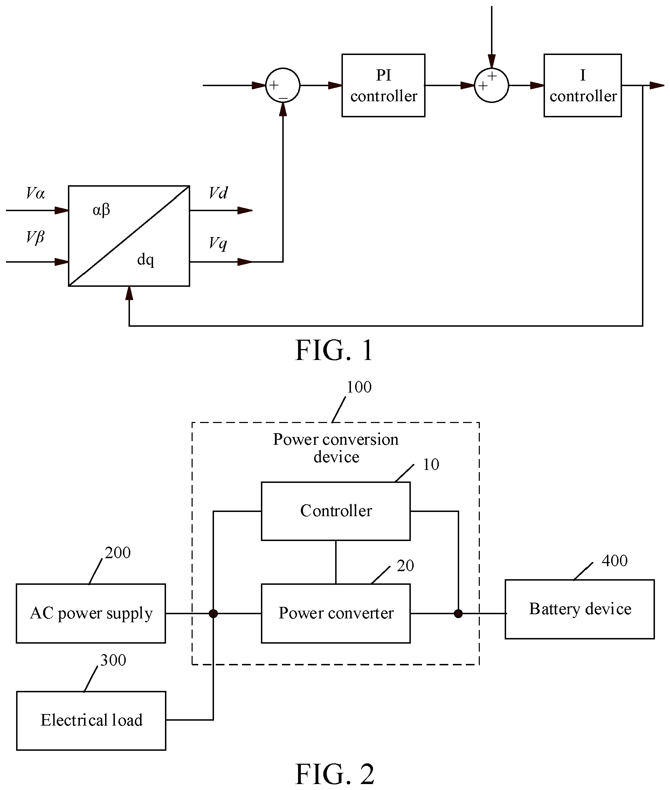

Whether an uninterruptible power supply (UPS) can quickly detect, when a mains supply is subjected to a power failure, that the mains supply is subjected to a power failure and quickly switch the power supply is one of the important performance indicators for measuring the UPS. In the related art, an alternating current (AC) phase-locked loop algorithm is usually used to detect a voltage amplitude of the mains supply. The voltage amplitude of the mains supply is a voltage effective value of the mains supply. The voltage amplitude of the mains supply can be obtained only after at least one power frequency period (that is, a period of the mains supply), which needs a relatively long duration. Specifically, as shown in FIG. 1, the AC phase-locked loop algorithm transforms three-phase electric quantities in a static coordinate system abc into two-phase electric quantities $V_\alpha$ and $V_\beta$ (correspondingly, a clark transformation) in a static coordinate system $\alpha\beta$, and then transforms two-phase electric quantities $V_\alpha$ and $V_\beta$ in the static coordinate system $\alpha\beta$ into direct quantities $V_d$ and $V_q$ (correspondingly, a park transformation) in a rotating coordinate system dq. $V_d$ represents the voltage amplitude of the mains supply. Therefore, when $V_d$ falls to a specific threshold, it may be considered that the mains supply is subjected to a power failure. When $V_d$ exceeds the specific threshold, it also indicates that the voltage amplitude of the mains supply cannot satisfy a current condition, and it may also be considered that the mains supply is subjected to a power failure.

However, an integration element exists in a loop in the AC phase-locked loop algorithm. For example, in FIG. 1, the phase-locked loop is provided with a proportional integral PI controller and an integral I controller in the loop. However, the integration element needs a specific integration time. Therefore, a time delay of the AC phase-locked loop algorithm is relatively long, and a detection speed is relatively slow. When a sudden power failure from the mains supply is caused by an abnormal operation on a mains supply grid side or a line fault, it takes a relatively long time (a time above at least one power frequency period is usually required) to detect that the voltage amplitude of the mains supply decreases below a threshold, which results in a relatively long time for switching to the power supply, that is, a relatively long UPS switching time.

Therefore, this application provides a power failure detection method, a power conversion device, and an energy storage system, which can quickly detect a real-time voltage amplitude of an AC without involving complex phase-locked loop calculation, so as to timely and rapidly detect that the AC is subjected to a power failure, thereby helping timely and rapidly switch the power supply.

The technical solutions of this application are further described in detail below with reference to the drawings.

FIG. 2 is a schematic diagram of an application scenario of a power failure detection method according to an embodiment of this application. In the scenario shown in FIG. 2, a controller 10 is connected to a power converter 20. The power converter 20 is further connected to an AC power supply 200, an electrical load 300, and a battery device 400. The AC power supply 200 may be, for example, a mains supply grid or another microgrid. The electrical load 300 may include an AC load.

When the AC power supply 200 normally supplies power, the AC power supply 200 may directly supply power to the electrical load 300 through a bypass. The power converter 20 may not operate. When an input power of the AC power supply 200 is greater than a required power of the electrical load 300, and the battery device 400 needs to be charged, the controller 10 may control the power converter 20 to operate, so as to convert power supply of the AC power supply 200 to supply power to the battery device 400. Once it is detected that the AC power supply 200 is subjected to a power failure, the controller 10 needs to control the power converter 20 to perform mode switch, so that the power converter 20 converts power supply of the battery device 400 and supplies power to the electrical load 300. To ensure normal power supply for the electrical load 200, the power failure of the AC needs to be quickly detected to perform mode switch of the power converter 20.

It may be understood that the power failure detection method in this embodiment may be applicable to the foregoing application scenario, or may be applicable to another application scenario in which the power failure detection needs to be performed on an AC.

Next, the power failure detection method provided in the embodiments of this application is described.

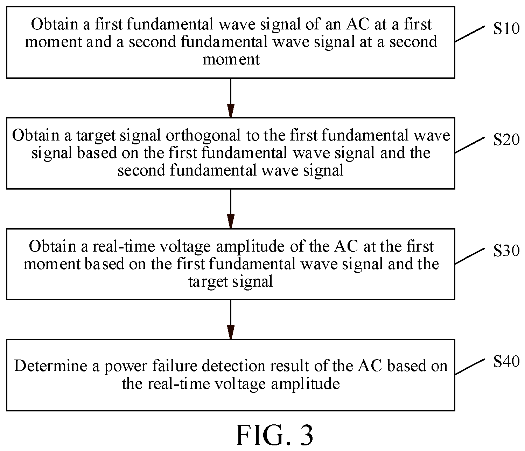

FIG. 3 is a power failure detection method according to an embodiment of this application. The method may be performed by the controller 10 in FIG. 2, or may be implemented by a dedicated power failure detection controller.

As shown in FIG. 3, the power failure detection method includes the following steps.

S10: Obtain a first fundamental wave signal of an AC at a first moment and a second fundamental wave signal at a second moment.

It may be understood that the AC includes a fundamental wave signal and a harmonic signal. The fundamental wave signal is a main component of an AC, the harmonic signal is interference, and a frequency of the harmonic signal is usually an integer multiple of a frequency of the fundamental wave signal. Therefore, the controller 10 may periodically obtain an electrical signal of the AC, extract the fundamental wave signal from the electrical signal of the AC, and use a real-time voltage amplitude of the fundamental wave signal as a real-time voltage amplitude of the AC. After obtaining the fundamental wave signal each time, the controller 10 may further perform information recording and storage on the obtained fundamental wave signal for subsequent use.

In step S10, the first moment is a current moment, and the second moment differs from the first moment by N sampling periods $T_s$.

Specifically, the second moment is earlier than the first moment by N sampling periods $T_s$.

N is a positive integer, which may be, for example, 3, 5, 7, or 8, and is not limited herein. The sampling period $T_s$ may be understood as a time interval at which the fundamental wave signal is sampled, and a value of the sampling period $T_s$ may be correspondingly set based on actual parameters of the power converter 20 and the controller 10, which is not limited herein. In this embodiment of this application, the sampling period $T_s$ is far less than a period of the AC. In an embodiment, the sampling period $T_s$ may reach a millisecond level or even a microsecond level, which, for example, may be set to 41 microseconds. Using an example in which a frequency of the AC is 50 Hz, a period corresponding to the AC is 20 milliseconds, which is obviously greater than the sampling period $T_s$ of 41 microseconds.

In this embodiment of this application, the AC is a sine signal. Therefore, the first fundamental wave signal and the second fundamental wave signal are both sine signals. The first fundamental wave signal may be represented as $V_m \sin \varphi_1$, and the second fundamental wave signal may be represented as $V_m \sin \varphi_2$. $V_m$ is a required real-time voltage amplitude, $\varphi_1$ is a phase of the first fundamental wave signal, and $\varphi_2$ is a phase of the second fundamental wave signal. A phase difference between the second fundamental wave signal and the first fundamental wave signal is $\varphi_2 - \varphi_1 = N\omega T_s$. $\omega$ is an angular frequency of a fundamental wave signal, and $\omega = 2\pi f$, where $f$ is a frequency of a fundamental wave signal.

S20: Obtain a target signal orthogonal to the first fundamental wave signal based on the first fundamental wave signal and the second fundamental wave signal.

It may be understood that the target signal may be represented as $V_m \sin \varphi_3$, where $\varphi_3$ is a phase of the target signal. That the target signal is orthogonal to the first fundamental wave signal means that the phase difference between the target signal and the first fundamental wave signal is $|\varphi_3 - \varphi_2| = \pi/2$.

Because a binary angle sum difference formula of a sine function has been proved, one sine function may be split into another sine function. Therefore, in step S20, the second fundamental wave signal may be decomposed into expressions related to the first fundamental wave signal and the target signal. Therefore, if the second fundamental wave signal and the first fundamental wave signal are known, the target signal may be obtained based on the expressions of the first fundamental wave signal and the second fundamental wave signal.

S30: Obtain a real-time voltage amplitude $V_m$ of the AC at the first moment based on the first fundamental wave signal and the target signal.

Because a quadratic relationship exists between the first fundamental wave signal and the target signal that are orthogonal to each other, that is, $(V_m \sin \varphi_1)^2 + (V_m \sin \varphi_3)^2 = V_m^2$. The quadratic relationship may eliminate a phase, so that the result is only related to the real-time voltage amplitude $V_m$. Therefore, in step S30, the real-time voltage amplitude $V_m$ at the first moment may be obtained based on the first fundamental wave signal, the target signal, and the quadratic relationship between the first fundamental wave signal and the target signal.

It may be understood that after obtaining the real-time voltage amplitude $V_m$ at the first moment each time, the controller 10 may also perform recording and storage on the real-time voltage amplitude $V_m$ for subsequent use.

S40: Determine a power failure detection result of the AC based on the real-time voltage amplitude.

When the AC is in a power failure state, the real-time voltage amplitude finally decreases to 0. On the contrary, when the AC is not in a power failure state, the real-time voltage amplitude is stable within a specific range. Therefore, in step S40, in a case that a change amplitude of the real-time voltage amplitude is large and exceeds a corresponding voltage threshold, it may be determined that the AC is subjected to a power failure. In a case that the real-time voltage amplitude is stable within a certain range and does not exceed a corresponding voltage threshold, it may be determined that the AC is not subjected to a power failure.

In the power failure detection method provided in this embodiment of this application, the first fundamental wave signal of the AC at the first moment and the second fundamental wave signal of the AC at the second moment are obtained, and the target signal orthogonal to the first fundamental wave signal is obtained based on the two fundamental wave signals. Therefore, the real-time voltage amplitude of the AC at the first moment may be directly obtained based on the first fundamental wave signal and the target signal that are orthogonal to each other. In this embodiment, the power failure detection on the AC may be implemented through only N sampling periods. However, in a conventional calculation method of the phase-locked loop, the power failure detection needs to be implemented through at least one AC period. In this embodiment, to ensure detection precision, hundreds of sampling points exist within one AC period. In other words, hundreds of sampling periods are set within one AC period. Therefore, a duration of the N sampling periods is far less than a duration of one AC period, so as to facilitate timely and rapid discovery of a power failure event of the AC, thereby facilitating rapid switching to a power supply that can supply power and shortening a UPS switching time. In addition, the power failure detection method provided this embodiment of this application may also reduce calculation complexity and reduce calculation costs, and is not affected by the phase detection precision of the AC.

For better understanding, the method provided in this embodiment of this application is further described below through two embodiments.

In an embodiment, the first fundamental wave signal $V_m \sin \varphi_1$ may be further expressed as $V_m \sin(\omega t)$, where t is a time. Correspondingly, the second fundamental wave signal $V_m \sin \varphi_2$ may be further expressed as $V_m \sin(\omega t + N\omega T_s)$. The target signal $V_m \sin \varphi_3$ may be further expressed as $V_m \sin(\omega t + \pi/2)$.

Further, in step S20, based on a quadratic sum difference formula in a sine function, the second fundamental wave signal $V_m \sin(\omega t + N\omega T_s)$ may be converted into expression (1):

$$V_m \sin(\omega t + N\omega T_s) = V_m[\sin(\omega t)\cos(N\omega T_s) + \cos(\omega t)\sin(N\omega T_s)] \qquad (1)$$

where $V_m \cos(N\omega T_s)$ is a cosine signal orthogonal to a sine signal $V_m \sin(N\omega T_s)$.

Because conversion may be performed between the sine signal and the cosine signal that are orthogonal to each other, $V_m \cos(\omega t)$ may be represented as a target signal $V_m \sin(\omega t + \pi/2)$. Therefore, expression (1) may be converted into expression (2):

$$V_m sin(\omega t + N\omega T_s) = V_m[sin(\omega t)\,cos(N\omega T_s) + sin(\omega t + \pi/2)\,sin(N\omega T_s)] \qquad (2).$$

Further, the target signal may be obtained based on expression (2):

$$V_m\, sin(\omega t + \pi/2) = V_m\left[\frac{sin(\omega t + N\omega T_s)}{sin(N\omega T_s)} - \frac{sin(\omega t)\,cos(N\omega T_s)}{sin(N\omega T_s)}\right] \qquad (3).$$

It may be understood that, the first fundamental wave signal $V_m sin(\omega t)$ and the second fundamental wave signal $V_m sin(\omega t + N\omega T_s)$ may be obtained through sampling. Therefore, when $N\omega T_s$ is determined, corresponding $sin(N\omega T_s)$ and $cos(N\omega T_s)$ can be both obtained through calculation. Therefore, the target signal $V_m\, sin(\omega t + \pi/2)$ may be obtained based on expression (3).

Because a quadratic relationship exists between the first fundamental wave signal and the target signal:

$$(V_m\, sin\,\varphi_1)^2 + (V_m\, sin\,\varphi_3)^2 = (V_m\, sin\,\omega t)^2 + [V_m\, sin(\omega t + \pi/2)]^2 = V_m^2$$ , step S30 may include the following steps.

Step I: Calculate a sum of a square of the first fundamental wave signal and a square of the target signal. In other words, calculation is performed on $(V_m\, sin\,\varphi_1)^2 + (V_m\, sin\,\varphi_3)^2$.

Step II: Use a square root of the sum as the real-time voltage amplitude of the AC. In other words, calculation is performed on $\sqrt{(V_m\, sin\,\varphi_1)^2 + (V_m\, sin\,\varphi_3)^2}$. A calculation result is the real-time voltage amplitude $V_m$ at the first moment.

That is, the real-time voltage amplitude $V_m$ at the first moment is obtained based on expression (4):

$$V_m = \sqrt{[V_m\, sin(\omega t)]^2 + [V_m\, sin(\omega t + \pi/2)]^2} \qquad (4).$$

Similarly, in another embodiment, the first fundamental wave signal $V_m\, sin\,\varphi_1 = V_m\, sin(\omega t)$. Correspondingly, the second fundamental wave signal $V_m\, sin\,\varphi_2 = V_m\, sin(\omega t + N\omega T_s)$. The target signal $V_m\, sin\,\varphi_3 = V_m\, sin(\omega t - \pi/2) = -V_m\, cos(\omega t)$.

Referring to the calculation process of the foregoing embodiment, in step S20, the target signal may be obtained based on expression (5):

$$V_m\, sin(\omega t - \pi/2) = V_m\left[\frac{sin(\omega t)\,cos(N\omega T_s)}{sin(N\omega T_s)} - \frac{sin(\omega t + N\omega T_s)}{sin(N\omega T_s)}\right] \qquad (5).$$

Because a quadratic relationship exists between the first fundamental wave signal and the target signal:

$$(V_m\, sin\,\varphi_1)^2 + (V_m\, sin\,\varphi_3)^2 = (V_m\, sin\,\omega t)^2 + [V_m\, sin(\omega t - \pi/2)]^2 = V_m^2$$ . in step S30, the real-time voltage amplitude $V_m$ at the first moment is obtained based on the first fundamental wave signal and the target signal through expression (6):

$$V_m = \sqrt{[V_m\, sin(\omega t)]^2 + [V_m\, sin(\omega t - \pi/2)]^2} \qquad (6).$$

It may be learned from the above that a process of step S20 to step S30 may be understood as obtaining the real-time voltage amplitude $V_m$ at the first moment with reference to expressions (3) and (4) or with reference to expressions (5) and (6).

It may be understood that when the AC power supply 200 normally supplies power, a waveform of the AC outputted by the AC power supply is a sine wave, an instantaneous value of the sine wave periodically changes with the time, and an amplitude of the sine wave remains unchanged. Therefore, when the AC power supply 200 normally supplies power, the real-time voltage amplitude $V_m$ obtained through the method provided in the embodiments of this application is relatively stable.

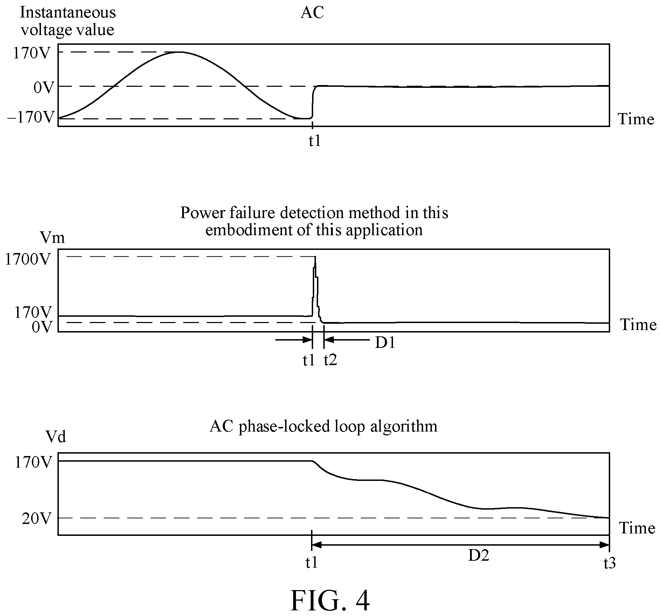

For example, referring to FIG. 4, using an example in which the AC power supply 200 is a low-voltage grid, before the moment t1, an instantaneous voltage value of the AC periodically changes within a voltage range of [-170V, +170V], and a real-time voltage amplitude $V_m$ of the AC is kept at 170V. Therefore, a waveform of the real-time voltage amplitude $V_m$ presents a stable horizontal line segment. At the moment t1, the AC power supply 200 is suddenly subjected to a power failure. Therefore, an instantaneous voltage value of the AC outputted by the AC power supply quickly changes from -170V to 0. In other words, the first fundamental wave signal at the moment t1 suddenly changes to 0. The waveform of the AC is no longer a sine wave, but suddenly turns to a base line at which 0V is located.

Because the AC power supply 200 is not subjected to a power failure before the moment t1, the second fundamental wave signal obtained before the moment t1 still has a specific instantaneous voltage value, and a polarity of the instantaneous voltage value may be positive or negative. For example, in FIG. 4, the instantaneous voltage value is negative, which is approximately -170V.

Because $V_m sin(\omega t)$ is 0, $V_m sin(\omega t + N\omega T_s)$ is not 0, and $V_m sin(N\omega T_s)$ is also not 0, referring to expression (3) or (5), $V_m sin(\omega t - \pi/2)$ is not 0. A value thereof suddenly changes to 0 because of $V_m sin(\omega t)$. $V_m sin(\omega t + N\omega T_s)$ and $V_m sin(N\omega T_s)$ increase with a corresponding instantaneous voltage value. For example, in FIG. 4, an instantaneous voltage value of $V_m sin(\omega t)$ is approximately -170V. Therefore, a real-time voltage amplitude $V_m$ at the moment t1 obtained through calculation by using expressions (3), (4), (5), or (6) is approximately 1700V.

It can be learned that, in this embodiment of this application, the real-time voltage amplitude $V_m$ associated with the first fundamental wave signal and the second fundamental wave signal does not immediately decrease to 0, but suddenly increases at the moment t1. It may be seen from FIG. 4 that the real-time voltage amplitude $V_m$ increases from 170V to 1700V.

After the moment t1, the AC is always in a state of 0 voltage, and a waveform of the AC coincides with a base line of 0V. After N sampling periods $T_s$, the first fundamental wave signal is still 0, and the second fundamental wave signal and the third fundamental wave signal are also updated to 0. Therefore, after reaching 1700V, the real-time voltage amplitude $V_m$ quickly decreases to below 170V, and finally decreases to 0 at the moment t2.

It may be seen from FIG. 4 that, when the AC is subjected to a power failure, the power failure detection method in this embodiment may detect that the real-time voltage amplitude $V_m$ changes from 170V to 0V based on the data during N sampling periods $T_s$. In addition, a time of the real-time voltage amplitude $V_m$ from 170V to 0V is a time D1 from the moment t1 to the moment t2, which is short. However, in the related art, a time D2 of the voltage amplitude $V_d$ from 170V to 20V detected through the AC phase-locked loop algorithm is much greater than D1.

In addition, the sampling period $T_s$ in the embodiments of this application may reach a microsecond level, and a period of the AC tracked by the phase-locked loop is usually a millisecond level, which is much greater than N sampling periods $T_s$. On the other hand, a time delay (for example, the time delay may reach 3 ms to 4 ms) exists in an integration element of the AC phase-locked loop algorithm. Therefore, compared with the phase-locked loop, in this embodiment of this application, the fundamental wave signal of the AC may be obtained more rapidly, and then the change of the detected real-time voltage amplitude $V_m$ may be presented more rapidly and instantly.

Therefore, based on the method provided in this embodiment of this application, the change of the real-time voltage amplitude $V_m$ may be detected more quickly and timely, and then the power failure of the AC is more quickly detected. In addition, when the AC is in a power failure state, the change amplitude of the real-time voltage amplitude $V_m$ detected through the method provided in this embodiment of this application is more significant and pronounced, and the change amplitude first increases and then decreases. Therefore, it is easier to detect the power failure of the AC through the method provided in this embodiment of this application, and it is more beneficial to improve accuracy of power failure detection.

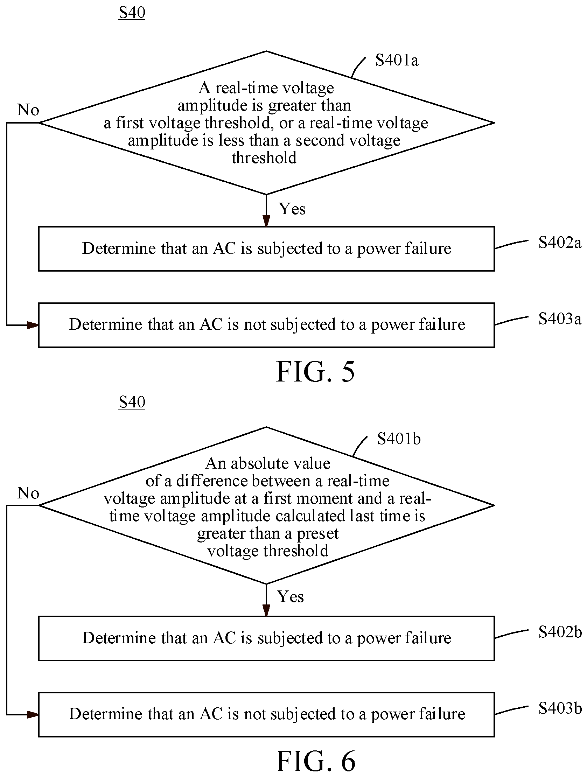

Therefore, as shown in FIG. 5, in step S40, the process of determining a power failure detection result of the AC based on the real-time voltage amplitude may include the following steps.

S401a: Determine whether the real-time voltage amplitude $V_m$ is greater than the first voltage threshold, or determine whether the real-time voltage amplitude $V_m$ is less than the second voltage threshold.

The first voltage threshold corresponds to a situation that the real-time voltage amplitude $V_m$ in FIG. 4 suddenly rises at the moment t1. The second voltage threshold corresponds to a situation that the real-time voltage amplitude $V_m$ in FIG. 4 rises and then suddenly falls. Therefore, the first voltage threshold is greater than the second voltage threshold.

It may be understood that specific values of the first voltage threshold and the second voltage threshold may be correspondingly set based on an actual situation, which are not limited herein. For example, the first voltage threshold may be set to any value or a range of values within (170V, 1700V], such as 230V. The second voltage threshold may be set to any value or a range of values within [0, 170V), such as 90V.

S402a: Determine that the AC is subjected to a power failure when the real-time voltage amplitude $V_m$ is greater than the first voltage threshold or the real-time voltage amplitude $V_m$ is less than the second voltage threshold.

S403a: Determine that the AC is not subjected to a power failure when the real-time voltage amplitude $V_m$ is not greater than the first voltage threshold or the real-time voltage amplitude $V_m$ is not less than the second voltage threshold.

It may be learned that, in this embodiment of this application, provided that the real-time voltage amplitude $V_m$ is greater than the first voltage threshold or less than the second voltage threshold, it may be determined that the AC is subjected to a power failure.

Certainly, in some embodiments, the real-time voltage amplitude obtained through calculation this time may also be compared with the real-time voltage amplitude obtained previously, so as to determine whether the AC is subjected to a power failure.

Specifically, as shown in FIG. 6, the process of determining a power failure detection result of the AC based on the real-time voltage amplitude may include the following steps.

S401b: Determine whether an absolute value of a difference between the real-time voltage amplitude at the first moment and a real-time voltage amplitude calculated last time is greater than a preset voltage threshold.

The preset voltage threshold may be correspondingly set based on an actual situation, which is not limited herein. For example, the preset voltage threshold may be set to 60V, 80V, or the like.

S402b: Determine that the AC is subjected to a power failure when an absolute value of a difference between the real-time voltage amplitude at the first moment and a real-time voltage amplitude calculated last time is greater than a preset voltage threshold.

S403b: Determine that the AC is not subjected to a power failure when an absolute value of a difference between the real-time voltage amplitude at the first moment and a real-time voltage amplitude calculated last time is not greater than a preset voltage threshold.

It may be learned that, in this embodiment of this application, provided that the change amplitude is greater than the preset voltage threshold when the current real-time voltage amplitude $V_m$ is compared with the real-time voltage amplitude calculated last time, it may be determined that the AC is subjected to a power failure.

In this embodiment of this application, the power failure detection method may further include the following.

Fundamental wave extraction is performed on the AC through a filter, to obtain a fundamental wave signal at a corresponding moment.

Therefore, the first fundamental wave signal $V_m \sin \varphi_1$ and the second fundamental wave signal $V_m \sin \varphi_2$ in step S10 may be both obtained through a filter. Because the sampling period $T_s$ may reach a microsecond level, the filter may rapidly obtain the fundamental wave signal at the corresponding moment.

In some embodiments, the filter may adopt a second-order generalized integrator (SOGI). It may be understood that the SOGI may only extract the fundamental wave signal from the AC, and the extracted fundamental wave signal has no phase delay. Therefore, it may be ensured that the target signal and the first fundamental wave signal obtained in the subsequent step S20 may have good sine and orthogonality, to help accurately obtain the real-time voltage amplitude $V_m$ at the first moment.

Certainly, in some other embodiments, the filter may adopt a band-pass filter or another circuit/module/unit/device that may extract the fundamental wave signal. It may be understood that the band-pass filter allows only a frequency band of the fundamental wave signal to pass, and effectively restrains a signal (for example, the harmonic signal) of another frequency. Therefore, the band-pass filter may accurately extract the fundamental wave signal and filter out another signal except the fundamental wave signal.

It should be noted that, for brevity, the foregoing method embodiments are described as a series of action combinations. However, it is to be appreciated by a person skilled in the art that this application is not limited to the described sequence of the actions, because some operations may be performed in another sequence or simultaneously according to this application.

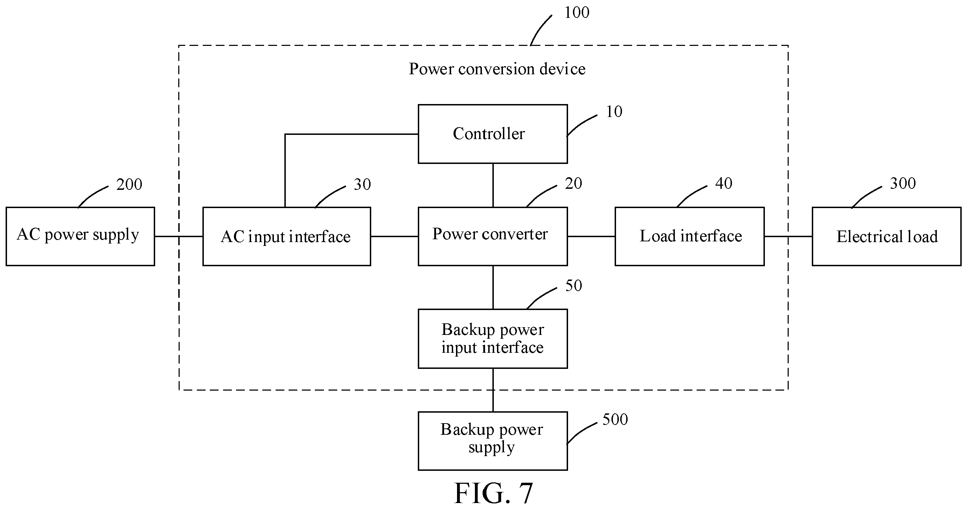

FIG. 7 is a schematic diagram of a power conversion device 100 according to an embodiment of this application.

As shown in FIG. 7, the power conversion device 100 may include an AC input interface 30, a backup power input interface 50, a load interface 40, a power converter 20, and a controller 10.

The AC input interface 30 is configured to electrically connect to an AC power supply 200. The AC power supply 200 may adopt a power supply that can provide an AC, such as a power grid.

The backup power input interface 50 is configured to electrically connect to a backup power supply 500. The backup power supply 500 may adopt a power supply that can supply power, such as a generator or a battery pack.

The load interface 40 is configured to electrically connect to an electrical load 300. The electrical load 300 may include an AC load. In some embodiments, the electrical load 300 may further include a direct current (DC) load.

The power converter 20 may adopt any circuit that may implement a power conversion function. A specific circuit structure thereof may be correspondingly set based on the connected AC power supply 200, the backup power supply 500, the electrical load 300, and the like, which is not limited herein. For example, in an embodiment, the power converter 20 may include an AC/AC converter, a bidirectional DC/AC converter, and a bidirectional DC/DC converter.

The power converter 20 is electrically connected to the AC input interface 30, the backup power input interface 50, and the load interface 40. In this way, the AC power supply 200, the AC input interface 30, the power converter 20, and the load interface 40 may form one power supply channel. The battery device 400, the backup power input interface 50, the power converter 20, and the load interface 40 may form another power supply channel.

The controller 10 may include a microcontroller unit (MCU), or another circuit, unit, module, or apparatus having a control function, which is not limited herein.

The controller 10 is further electrically connected to the AC input interface 30. Therefore, when the AC input interface 30 is connected to the AC power supply 200, the AC input interface 30 is connected to the AC. Further, the controller 10 may extract the fundamental wave signal in the AC from the AC input interface 30 through an internal filter, and may detect whether the AC power supply 200 is subjected to a power failure by performing the foregoing power failure detection method shown in FIG. 3 to FIG. 6. Certainly, in some embodiments, the filter may also be independently arranged and connected between the controller 10 and the AC input interface 30.

The controller 10 is further electrically connected to the power converter 20. Therefore, the controller 10 may control the power converter 20.

Specifically, when the AC input interface 30 is connected to the AC power supply 200 and the load interface 40 is connected to the electrical load 300, the controller 10 may control, based on a power failure condition of the AC power supply 200, the power converter 20 to switch to a corresponding power supply mode. Different power supply channels may be adopted for different power supply modes. For example, if the controller 10 determines that the AC power supply 200 is not subjected to a power failure, the controller 10 may control the power converter 20 to draw power from the AC power supply 200 through the AC input interface 30. In other words, the controller controls the power converter 20 to receive an AC provided by the AC power supply 200 through the AC input interface 30, perform power conversion on the AC, and then supply power to the electrical load 300 through the load interface 40, so that the electrical load 300 may be powered up to operate.

Further, when the AC input interface 30 is connected to the AC power supply 200, the load interface 40 is connected to the electrical load 300, and the backup power input interface 50 is also connected to the backup power supply 500, if the controller 10 determines that the AC power supply 200 is not subjected to a power failure, the controller 10 may further control the power converter 20 to simultaneously charge the battery device 400 through the backup power input interface 50 in a case that the AC power supply 200 has sufficient electrical energy (that is, an input power of the AC power supply 200 is greater than a required power of the electrical load 300) and the battery device 400 needs to be charged.

In a case that electrical energy of the AC power supply 200 is insufficient (that is, the input power of the AC power supply 200 is less than the required power of the electrical load 300), the controller 10 may further control the power converter 20 to obtain electrical energy of the battery device 400 through the backup power input interface 50, convert the electrical energy, and output the electrical energy to the electrical load 300 through the load interface 40, so as to avoid the electrical load 300 from being affected in normal operation due to insufficient power supply.

When the AC input interface 30 is connected to the AC power supply 200, the load interface 40 is connected to the electrical load 300, and the backup power input interface 50 is also connected to the backup power supply 500, if the controller 10 determines that the AC power supply 200 is subjected to a power failure, the controller 10 may further control the power converter 20 to stop obtaining power from the AC power supply 200 through the AC input interface 30, and switch to obtaining power from the backup power supply 500 through the backup power input interface 50. In other words, the controller controls the power converter 20 to receive only power supply from the backup power supply 500, and supply power to the electrical load 300 through the load interface 40 after power conversion is performed on the power supply from the backup power supply 500. In this way, the electrical load 300 may be avoided from being powered off.

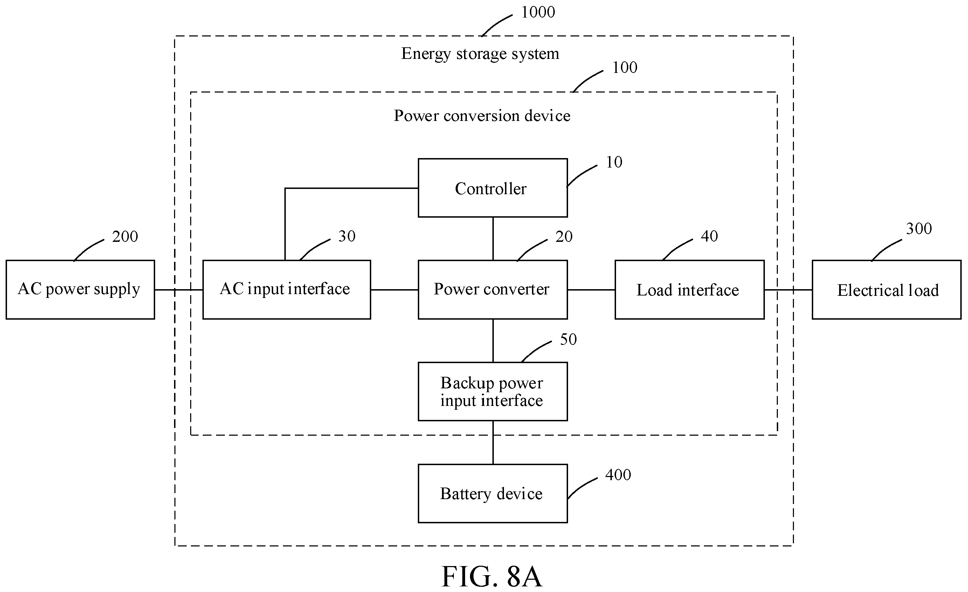

FIG. 8A is a schematic diagram of an energy storage system 1000 according to an embodiment of this application.

As shown in FIG. 8A, the energy storage system 1000 may include a power conversion device 100 and a battery device 400. It may be understood that the power conversion device 100 and the battery device 400 may be at least partially integrated, or the power conversion device 100 and the battery device 400 may be separately arranged, which is not limited herein.

In this embodiment of this application, the energy storage system 1000 is a UPS, and may continuously and stably supply power to an electrical load 300 through the power conversion device 100 and the battery device 400.

For the power conversion device 100, reference is made to the descriptions in the embodiment shown in FIG. 7. Details are not described herein again.

The battery device 400 is used as a backup power supply, and may be connected to a backup power input interface 50 of the power conversion device 100. Therefore, the power converter 20 in the power conversion device 100 may receive power from the battery device 400 through the backup power input interface 50, and further, may perform power conversion on electric energy of the battery device 400, and then supply power to the electrical load 300 through the load interface 40.

It may be understood that the battery device 400 may include a battery management system (BMS, not shown in the figure) and at least one battery core (not shown in the figure). The BMS may be connected to the controller 10 of the power conversion device 100, so that the controller 10 may further control whether the battery core discharges to the power conversion device 100 through the BMS, or control whether the battery core accepts charging from the power conversion device 100.

It may be understood that the structure shown in FIG. 8A does not constitute a specific limitation to the energy storage system 1000. In some other embodiments, the energy storage system 1000 may include more or fewer components than those shown in the figure, or some merged components, or some split components, or different component arrangements.

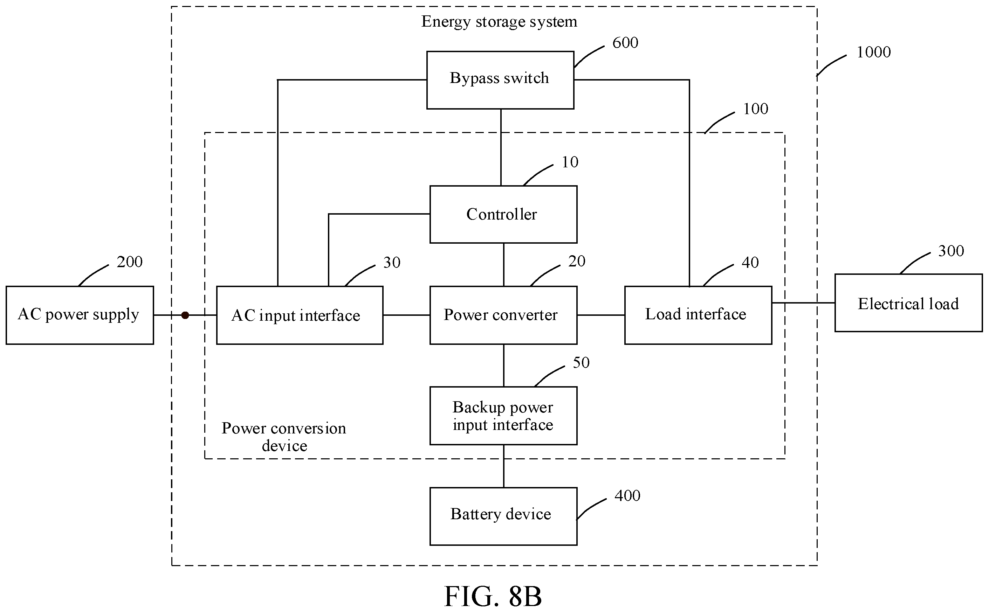

For example, in some embodiments, as shown in FIG. 8B, when the electrical load 300 is an AC load, the energy storage system 1000 may further include a bypass switch 600. The bypass switch 600 may be an electrically controlled switch, a mechanical switch such as a relay or a touch, or a semiconductor switch such as a triode or a MOSFET. It may be understood that the bypass switch 600 may be integrated with at least part of the power conversion device 100 and the battery device 400, or may be independently arranged, which is not limited herein.

One end of the bypass switch 600 is connected to the AC input interface 30 of the power conversion device 100, and an other end of the bypass switch 600 is connected to the load interface 40 of the power conversion device 100. Therefore, the AC power supply 200, the AC input interface 30, the bypass switch 600, and the load interface 40 may form a new power supply channel.

The bypass switch 600 may further be connected to the controller 10 in the power conversion device 100, and be controlled by the controller 10.

Based on such a design, when the AC input interface 30 is connected to the AC power supply 200, the load interface 40 is connected to the electrical load 300, the backup power input interface 50 is connected to the backup power supply 500, and the controller 10 determines that the AC power supply 200 is not subjected to a power failure, the controller 10 may control the bypass switch 600 to be turned on, so that an AC of the AC power supply 200 may be directly transmitted to the electrical load 300 through the bypass switch 600. In this case, the power conversion device 100 may not operate. If the electrical load 300 has a relatively large power supply requirement, the controller 10 may further control the power conversion device 100 to normally operate while controlling the bypass switch 600 to be turned on, so as to meet the power supply requirement of the electrical load 300.

Certainly, when the controller 10 determines that the AC power supply 200 is subjected to a power failure, the controller 10 may control the bypass switch 600 to be turned off, and control the power conversion device 100 to normally operate, so that the power converter 20 transmits electrical energy of the battery device 400 to the electrical load 300, to ensure that the electrical load 300 is not powered off.

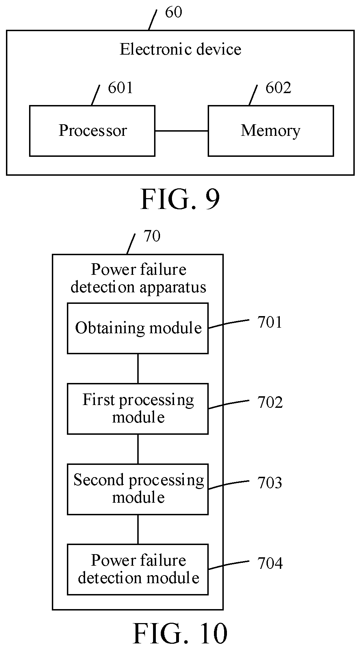

FIG. 9 is a schematic structural diagram of an electronic device 60 according to an embodiment of this application.

As shown in FIG. 9, the electronic device 60 may include a processor 601 and a memory 602.

The processor 601 may be a central processing unit (CPU), and may further be another general-purpose processor, a digital signal processor (DSP) 601, an application specific integrated circuit (ASIC), a field programmable gate array (FPGA), or another programmable logic device, a discrete gate or a transistor logic device, a discrete hardware component, or the like. The general-purpose processor may be a microprocessor, any conventional processor, or the like.

The memory 602 may be a read-only memory (ROM) or another type of static storage device that may store static information and an instruction, or a random access memory (RAM) or another type of dynamic storage device that may store information and an instruction, or may be an electrically erasable programmable read-only memory (EEPROM), a compact disc read-only memory (CD-ROM) or another compact disc storage, an optical disc storage (including a compact disc, a laser disc, an optical disc, a digital versatile disc, a Blu-ray optical disc, and the like), a magnetic disk storage medium or another magnetic storage device, or any other medium that can be configured to carry or store expected program code in a form of an instruction or a data structure and that may be accessed by a computer, but is not limited thereto. The memory 602 may exist independently, and is connected to the processor 601 through a bus. Alternatively, the memory 602 may be integrated with the processor 601.

The memory 602 is configured to store a program, an instruction, or code for performing the foregoing power failure detection method, and is controlled and executed by the processor 601. The processor 601 is configured to execute the program, the instruction, or the code stored in the memory 602. The program, the instruction, or the code stored in the memory 602 may perform some or all steps of the power failure detection method in the embodiments shown in FIG. 3, FIG. 5, and FIG. 6.

FIG. 10 is a schematic diagram of a power failure detection apparatus 70 according to an embodiment of this application. The power failure detection apparatus 70 may be configured to implement the foregoing power failure detection method.

As shown in FIG. 10, the power failure detection apparatus 70 includes an obtaining module 701, a first processing module 702, a second processing module 703, and a power failure detection module 704. The obtaining module 701, the first processing module 702, the second processing module 703, and the power failure detection module 704 are sequentially connected.

Specifically, the obtaining module 701 may be configured to obtain a first fundamental wave signal of an AC at a first moment and a second fundamental wave signal at a second moment, where the second moment differs from the first moment by N sampling periods, and N is a positive integer.

The first processing module 702 may be configured to obtain a target signal orthogonal to the first fundamental wave signal based on the first fundamental wave signal and the second fundamental wave signal.

The second processing module 703 may be configured to obtain a real-time voltage amplitude of the AC at the first moment based on the first fundamental wave signal and the target signal.

The power failure detection module 704 may be configured to determine a power failure detection result of the AC based on the real-time voltage amplitude.

It may be understood that division of the modules in the foregoing power failure detection apparatus 70 is merely used as an example for description. In another embodiment, the power failure detection apparatus 70 may be divided into different modules based on requirements, to complete all or some of the functions of the foregoing power failure detection apparatus 70.

Corresponding descriptions of the method embodiments shown in FIG. 3, FIG. 5, and FIG. 6 may also be correspondingly referred to for specific implementation of the modules in the embodiments of this application. Therefore, details are not described herein again.

Functional modules in the embodiments of this application may be all integrated into one processing module/unit, or each of the modules may be separately used as one module, or two or more modules may be integrated into one module. The foregoing integrated module may be implemented in the form of hardware, or may be implemented in the form of hardware and a software functional module.

When implemented in the form of a software functional module and sold or used as an independent product, the foregoing integrated module in this application may also be stored in a computer-readable storage medium. Based on such understanding, the technical solutions in the embodiments of this application or a part thereof that makes a contribution to the prior art may be essentially embodied in a form of a software product. The computer software product is stored in a storage medium, including several instructions to enable one computer device (which may be a personal computer, a server, a network device, or the like) to perform all or some of the methods in the embodiments of this application. However, the foregoing storage medium includes any medium that may store program code, such as a removable storage device, a ROM, a RAM, a magnetic disk, or an optical disc.

An embodiment of this application further provides a computer-readable storage medium configured to store a computer program or code. When the computer program or code is loaded and executed by a processor, the steps in the foregoing embodiments of the power failure detection method may be implemented, for example, FIG. 3, FIG. 5, and FIG. 6. The computer-readable storage medium includes volatile and nonvolatile media, and removable and non-removable media implemented by using any method or technology used for storing information (for example, a computer readable instruction, a data structure, a program module, or another data). For a specific implementation of the computer-readable storage medium, reference is made to the description of the memory 602 in FIG. 9. Details are not described herein again.

Finally, it should be noted that the foregoing embodiments are merely used to describe the technical solutions of this application, but not intended to limit this application. Although this application has been described in detail with reference to preferred embodiments, it should be understood by a person skilled in the art that modifications or equivalent replacements may be made to the technical solutions of this application without departing from the spirit and scope of the technical solutions of this application.

**Claims**

1. A power failure detection method, comprising:

   obtaining a first fundamental wave signal of an alternating current (AC) at a first moment and a second fundamental wave signal at a second moment, wherein the second moment differs from the first moment by N sampling periods, and N is a positive integer;
   obtaining a target signal orthogonal to the first fundamental wave signal based on the first fundamental wave signal and the second fundamental wave signal;
   obtaining a real-time voltage amplitude of the AC at the first moment based on the first fundamental wave signal and the target signal; and
   determining a power failure detection result of the AC based on the real-time voltage amplitude.

2. The power failure detection method according to claim 1, wherein the determining a power failure detection result of the AC based on the real-time voltage amplitude comprises:

   determining that the AC is subjected to a power failure when the real-time voltage amplitude is greater than a first voltage threshold; or
   determining that the AC is subjected to a power failure when the real-time voltage amplitude is less than a second voltage threshold, wherein
   the first voltage threshold is greater than the second voltage threshold.

3. The power failure detection method according to claim 1, wherein the determining a power failure detection result of the AC based on the real-time voltage amplitude comprises:
   determining that the AC is subjected to a power failure when an absolute value of a difference between the real-time voltage amplitude at the first moment and a real-time voltage amplitude calculated last time is greater than a preset voltage threshold.

4. The power failure detection method according to claim 1, wherein the obtaining a target signal orthogonal to the first fundamental wave signal based on the first fundamental wave signal and the second fundamental wave signal comprises performing calculation based on the following expression to obtain the target signal:

$$V_m \sin(\omega t + \pi/2) = V_m \left[ \frac{\sin(\omega t + N\omega T_s)}{\sin(N\omega T_s)} - \frac{\sin(\omega t)\cos(N\omega T_s)}{\sin(N\omega T_s)} \right]$$

wherein $V_m$ is the real-time voltage amplitude, $\omega$ is an angular frequency, t is time, $T_s$ is a sampling period, $V_m \sin(\omega t + \pi/2)$ is the target signal, $V_m \sin(\omega t)$ is the first fundamental wave signal, and $V_m \sin(\omega t + N\omega T_s)$ is the second fundamental wave signal.

5. The power failure detection method according to claim 1, wherein the obtaining a real-time voltage amplitude of the AC at the first moment based on the first fundamental wave signal and the target signal comprises:

    calculating a sum of a square of the first fundamental wave signal and a square of the target signal; and
    using a square root of the sum as the real-time voltage amplitude of the AC.

6. The power failure detection method according to claim 1, further comprising:
performing fundamental wave extraction on the AC through a filter, to obtain a fundamental wave signal at a corresponding moment.

7. The power failure detection method according to claim 6, wherein the filter is a second-order generalized integrator (SOGI).

8. A power conversion device, comprising a power converter, an AC input interface, a backup power input interface, a load interface, and a controller, wherein

    the AC input interface is configured to connect to an AC power supply to receive an AC;
    the load interface is configured to connect to an electrical load;
    the backup power input interface is configured to connect to a backup power supply to receive power from the backup power supply;
    the power converter is connected to the AC input interface, the load interface, and the backup power input interface, and the power converter is configured to perform power conversion on power supplied by the AC or the backup power supply and then supply power to the electrical load through the load interface; and
    the controller is electrically connected to the AC input interface and the power converter, and the controller is configured to control the power converter, and further configured to perform the power failure detection method according to any one of claims 1 to 7.

9. The power conversion device according to claim 8, wherein the controller is configured to:

    control the power converter to draw power from the AC power supply when the AC power supply is not in a power failure state; and
    control the power converter to draw power from the backup power supply when the AC power supply is in a power failure state.

10. An energy storage system, comprising a power conversion device and a battery device, wherein the power conversion device is the power conversion device according to claim 8 or 9.

FIG. 1

FIG. 2

Obtain a first fundamental wave signal of an AC at a first moment and a second fundamental wave signal at a second moment — S10

Obtain a target signal orthogonal to the first fundamental wave signal based on the first fundamental wave signal and the second fundamental wave signal — S20

Obtain a real-time voltage amplitude of the AC at the first moment based on the first fundamental wave signal and the target signal — S30

Determine a power failure detection result of the AC based on the real-time voltage amplitude — S40

FIG. 3

Instantaneous
voltage value

AC

170V

0V

−170V

Time

t1

Power failure detection method in this
embodiment of this application

Vm

1700V

170V
0V

Time

D1

t1 t2

AC phase-locked loop algorithm

Vd

170V

20V

Time

t1

D2

t3

FIG. 4

S40

```
                              ┌─────────────────────────────┐ S401a
                         ╱           A real-time voltage           ╲
                       ╱             amplitude is greater than        ╲
   No        ◄────────   a first voltage threshold, or a real-time voltage
                       ╲        amplitude is less than a second voltage    ╱
                         ╲              threshold              ╱
                              └─────────────────────────────┘
                                          │ Yes
                                          ▼
              ┌──────────────────────────────────────────────┐
              │  Determine that an AC is subjected to a power failure  │──── S402a
              └──────────────────────────────────────────────┘

              ┌──────────────────────────────────────────────┐
              │ Determine that an AC is not subjected to a power failure │──── S403a
              └──────────────────────────────────────────────┘
```

## FIG. 5

S40

```
                              ┌─────────────────────────────┐ S401b
                         ╱              An absolute value             ╲
                       ╱        of a difference between a real-time      ╲
   No        ◄────────  voltage amplitude at a first moment and a real-
                       ╲   time voltage amplitude calculated last time is   ╱
                         ╲           greater than a preset           ╱
                              ╲           voltage threshold          ╱
                              └─────────────────────────────┘
                                          │ Yes
                                          ▼
              ┌──────────────────────────────────────────────┐
              │  Determine that an AC is subjected to a power failure  │──── S402b
              └──────────────────────────────────────────────┘

              ┌──────────────────────────────────────────────┐
              │ Determine that an AC is not subjected to a power failure │──── S403b
              └──────────────────────────────────────────────┘
```

## FIG. 6

FIG. 7

EP 4 756 438 A1

FIG. 8A

FIG. 8B

EP 4 756 438 A1

/ 60

**Electronic device**

/ 601

Processor

/ 602

Memory

## FIG. 9

/ 70

**Power failure detection apparatus**

Obtaining module — 701

First processing module — 702

Second processing module — 703

Power failure detection module — 704

## FIG. 10

## INTERNATIONAL SEARCH REPORT

| International application No. |
|---|
| **PCT/CN2024/109437** |

**A. CLASSIFICATION OF SUBJECT MATTER**

G01R19/165(2006.01)i; G01R19/04(2006.01)i; H02J9/06(2006.01)i

According to International Patent Classification (IPC) or to both national classification and IPC

**B. FIELDS SEARCHED**

Minimum documentation searched (classification system followed by classification symbols)

IPC:G01R H02J

Documentation searched other than minimum documentation to the extent that such documents are included in the fields searched

Electronic data base consulted during the international search (name of data base and, where practicable, search terms used)

CNTXT: CNABS; CNKI; WPABS; ENTXT; ENTXTC; IEEE: 正浩创新, 吴东, 陈熙, 王雷, 李为汉, 掉电, 检, 测, 基波, 周期, 采样, 正交, 正弦, 实时, 实际, 交流, 电压, 阈值, 阀值, 平方, 功率, 变换, 转换, 变化, 接口, 负载, 控制, 供电, 电源, supply failure, AC, alter+ current, power, convers+, voltage, sampl+, period+, control

**C. DOCUMENTS CONSIDERED TO BE RELEVANT**

| Category* | Citation of document, with indication, where appropriate, of the relevant passages | Relevant to claim No. |
|---|---|---|
| PX | CN 117169580 A (SHENZHEN ECOFLOW INNOVATION TECHNOLOGY CO., LTD.) 05 December 2023 (2023-12-05) <br> claims 1-10 | 1-10 |
| X | CN 114689926 A (QINGDAO HAIER REFRIGERATOR CO., LTD. et al.) 01 July 2022 (2022-07-01) <br> description, paragraphs [0007]-[0079] | 1-3, 6, 7 |
| A | CN 116381481 A (SHENZHEN ECOFLOW INNOVATION TECHNOLOGY CO., LTD.) 04 July 2023 (2023-07-04) <br> entire document | 1-10 |
| A | CN 109164293 A (SHENZHEN HELLO TECHNOLOGY ENERGY CO., LTD.) 08 January 2019 (2019-01-08) <br> entire document | 1-10 |
| A | US 11132010 B1 (APPLE INC.) 28 September 2021 (2021-09-28) <br> entire document | 1-10 |

☐ Further documents are listed in the continuation of Box C.　　☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **09 October 2024** | **23 October 2024** |

| Name and mailing address of the ISA/CN | Authorized officer |
|---|---|
| **China National Intellectual Property Administration (ISA/CN)** <br> **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2024/109437**

| Patent document cited in search report | | | Publication date (day/month/year) | Patent family member(s) | | | Publication date (day/month/year) |
|---|---|---|---|---|---|---|---|
| CN | 117169580 | A | 05 December 2023 | None | | | |
| CN | 114689926 | A | 01 July 2022 | None | | | |
| CN | 116381481 | A | 04 July 2023 | None | | | |
| CN | 109164293 | A | 08 January 2019 | None | | | |
| US | 11132010 | B1 | 28 September 2021 | US | 2022043469 | A1 | 10 February 2022 |
| | | | | US | 11579642 | B2 | 14 February 2023 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 2023109799748